# EUROPEAN PATENT APPLICATION

(11) **EP 3 109 897 A1**
(43) Date of publication of application: **28.12.2016**
(21) Application number: 15173468.8
(22) Date of filing: 23.06.2015
(51) Int. Cl.: H01L 23/495, H01G 2/06

(54) **A LEAD FRAME ASSEMBLY**

(71) Applicant: NXP B.V., 5656 AG Eindhoven (NL)
(72) Inventor: LICTAO, Crispulo, Jr. Estira, Redhill, Surrey RH1 1SH (GB)
(74) Representative: Crawford, Andrew

(57) **Abstract**

There is provided a lead frame assembly configured to receive an electronic component, comprising a lead frame portion including a first surface and a recessed portion, the recessed portion having a base recessed from the first surface and a side wall, the recessed portion configured to receive the electronic component and secure said electronic component to the lead frame with an adhesive that extends between the side wall of the recessed portion and the electronic component to control the bleeding of adhesive.

## Description

The present disclosure relates to a lead frame assembly. More specifically the present disclosure relates to the use of a recessed portion in a lead frame assembly configured to reduce the effect of the bleeding of an adhesive when an electronic component is received therein. It also relates to a method of fabricating a lead frame and mounting an electronic component therein. This disclosure also relates to a combination of a lead frame and an electronic component, such as in a package.

Lead frames are commonly used in electronic devices for mounting electronic components thereon, the electronic components being secured to the lead frames by an adhesive. Typically, lead frames are formed of copper and coated in a layer of silver which serves to prevent oxidation of the copper surface. A disadvantage of the silver layer is that it results in a low surface tension for the adhesive in comparison to a bare copper surface. This is disadvantageous, as an adhesive applied to mount an electronic device on the silver coated lead frame will bleed out, resulting in a small contact area between the component and the lead frame.

According to a first aspect of the present disclosure there is provided a lead frame assembly configured to receive an electronic component, comprising a lead frame portion including a first surface and a recessed portion, the recessed portion having a base recessed from the first surface and a side wall, the recessed portion configured to receive the electronic component and secure said electronic component to the lead frame portion with an adhesive applied to at least the recessed portion to secure the electronic component to the lead frame, said side wall providing control of the bleeding of adhesive.

This arrangement is advantageous as the recessed portion and particularly the side wall provides a barrier to maintain adhesive around the electronic component. This may increase the contact area of adhesive with the electronic component and/or the thickness of the adhesive between the lead frame and the electronic component. This may also serve to reduce wastage of adhesive as the side wall acts to suppress bleeding or spreading out of the adhesive away from the electronic component. The side wall is thus arranged relative to the electronic component it is to receive to control the spreading of adhesive away from the electronic component.

In one or more examples the lead frame assembly may further comprise an oxidation prevention layer. The oxidation prevention layer may extend over one or more of; the base of the recessed portion, the side wall of the recessed portion, at least a portion of the first surface or it may coat the whole lead frame assembly. The oxidation prevention layer may be electrically conductive. The oxidation prevention layer may be of silver.

The lead frame may be of copper. This is advantageous as other electronic components may be electrically connected to the lead frame by direct contact or by bond wires.

In the lead frame assembly, the base of the recessed portion may be substantially parallel to the first surface. The recess, between the first surface and the base of the recess, may be between 0.01 - 1 mm deep. More preferably, the recess, between the first surface and the base of the recess, may be between 0.05 and 0.5 mm deep. In particular, the recess, between the first surface and the base of the recess, may be between 0.75 and 0.15 mm deep.

The lead frame may be configured to receive adhesive over the base and side wall to engage with the electronic component. The lead frame may be configured to receive adhesive over a portion of the first surface adjacent to the recessed portion. Improved surface area contact may be made between the adhesive and the electronic component when the adhesive is applied over the base and the side wall of the recessed portion.

The electronic component to be received may be a capacitor.

The recessed portion may include a first terminal portion and a second terminal portion formed within the recessed portion for contacting separate terminals of the electronic component and the side wall adjacent the second terminal portion is configured to control adhesive bleed. This is advantageous as the lead frame portions may provide for separate electronic connections to different terminals of the electronic component.

The side wall may comprise a first section and a second section, the first and the second sections are substantially perpendicular to each other. The side wall may comprise a third section which is substantially perpendicular to the second section. The side wall may comprise a fourth section which is substantially perpendicular to the third section. The side wall sections may advantageously surround the electronic component and may prevent bleeding of adhesive away from different or all sides of the electronic component. In a second aspect of the disclosure there is provided an assembly comprising an electronic component, an adhesive and a lead frame assembly as described in the first aspect.

The adhesive may be an electrically conductive adhesive. The adhesive may be an epoxy adhesive or a die attach solder. The recess may be sized such that the electronic component is partially received in the recessed portion.

In a third aspect of the disclosure there is provided a method of fabricating an assembly comprising:
receiving a lead frame portion comprising a first surface and a recessed portion, the recessed portion having a base recessed from the first surface and a side wall;
providing adhesive to at least the recessed portion for securing an electronic component to the lead frame; and
placing the electronic component in the recessed portion such that it is secured to the lead frame by the adhesive, said side wall of the recessed portion controlling the bleeding of the adhesive.

The method may comprise the step of stamping the recessed portion into a lead frame.

The method may comprise the step of providing adhesive to extend over the base of the recessed portion, and optionally only over the base. The method may comprise the step of providing adhesive to extend over a portion of the first surface.

The method may comprise the step of forming an oxidation prevention layer over the base of the recessed portion, over a portion of the side wall and/or over a portion of the first surface.

The method step of receiving a lead frame portion receiving a lead frame portion wherein the recess of the lead frame portion comprises a first terminal portion and a second terminal portion formed within the recessed portion for contacting separate terminals of the electronic component and the side wall adjacent the second terminal portion is configured to control adhesive bleeding.

The method may comprise the step of placing the electronic component within the recessed portion so that first and second terminals of the electronic component engage with the corresponding first and second terminal portions of the recessed portion.

The step of providing adhesive may comprise providing adhesive in the recessed portion over the first terminal portion and the second terminal portion.

In a further aspect of this disclosure, we provide an electronic device including the assembly of the second aspect.

While the disclosure is amenable to various modifications and alternative forms, specifics thereof have been shown by way of example in the drawings and will be described in detail. It should be understood, however, that other examples, beyond the particular examples described, are possible as well. All modifications, equivalents, and alternative examples falling within the spirit and scope of the appended claims are covered as well.

The above discussion is not intended to represent every example or every implementation within the scope of the current or future Claim sets. The Figures and Detailed Description that follow also exemplify various examples. Various examples may be more completely understood in consideration of the following Detailed Description in connection with the accompanying Drawings.

One or more examples will now be described by way of example only with reference to the accompanying drawings in which:
Figure 1 shows one example of a lead frame assembly and an electronic component;
Figure 2 shows an example of a lead frame assembly having a recessed portion and an electronic component arranged in the recessed portion;
Figures 3A and 3B show examples of a lead frame assembly having a first terminal portion and a second terminal portion;
Figure 4 shows an example of a lead frame assembly having a first terminal portion and a second terminal portion and wherein the side wall has more than one section;
Figure 5 shows an example method of fabricating an assembly.
Figures 6A - 6F graphically represent an example method of fabricating a lead frame assembly;
Figure 7 shows an example electronic device including the lead frame assembly and electronic component.

Lead frames are metal structures used in chip packages to provide a mechanical support to an electronic component and carry signals between the outside of the package and the electronic component inside the package. Such packages may be mounted to a PCB by leads of the lead frame. Electronic components can be electrically connected to a lead frame either by direct mounting or via conducting wires. In some cases electrical components may be physically mounted on a lead frame but an electrical connection to the component will be made by bond wires. Lead frames are normally formed of conductive metals such as copper so that electrical connections between electronic components via the lead frame can be made. Some materials of which lead frames are commonly made, such as copper, undergo oxidation when exposed to air. Oxidation can be detrimental to performance and so an oxidation prevention layer may coat the lead frame in order to avoid this. The oxidation prevention layer is also preferably formed of a conducting layer and may include, for example, silver, nickel, gold or tin. Lead frames are often planar structures having a first major surface, an opposed second major surface and a plurality of leads extending from the edges of the structure. An electronic component may, for example, be mounted on the first major surface.

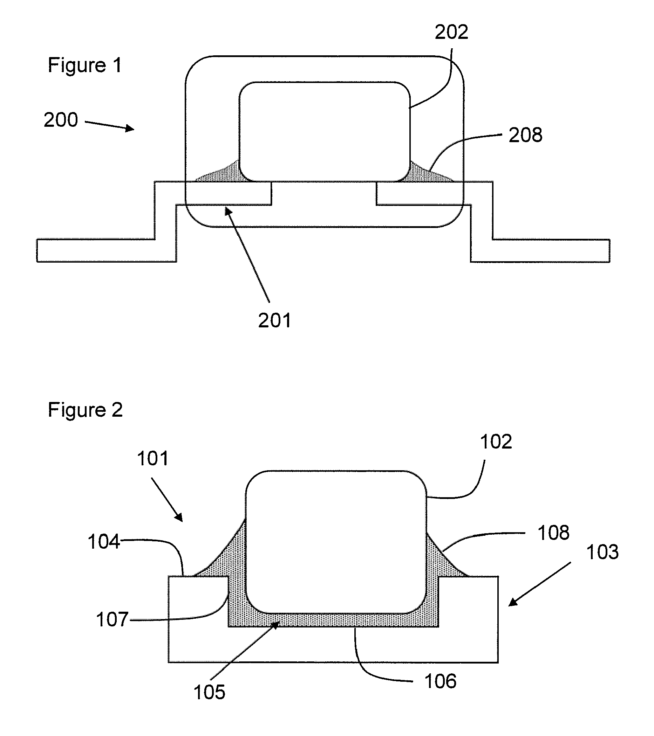

Figure 1 shows a cross section through a chip package 200 including a known lead frame 201. The electronic component 202 is mounted directly onto the lead frame 201 using an adhesive 208. The adhesive may be in contact with a base of the electronic component 202 to be attached to the lead frame 203 and some portion of the sides of the component 202. Adhesion to the side of an electronic component 202 in addition to the base increases the surface contact area of the adhesive 208 to the component and so allows for a more secure attachment. Inevitably, some portion of the adhesive 208 will not bond to the side of the electronic component 202 and will instead spread out across the surface of the lead frame 201 to either side of the electronic component 202. This effect is called bleeding of the adhesive 208, or simply bleeding and is disadvantageous for maintaining a reliable amount or thickness of adhesive 208 to securely mount the electronic component 202 on the lead frame. It has been observed that the use of an oxidation prevention layer may exacerbate this problem if said layer acts to reduce the surface tension of the adhesive 208. This can lead to a greater amount of adhesive bleeding compared to mounting on a copper lead frame.

Figure 2 shows an example lead frame assembly 101 configured to receive an electronic component 102, comprising a lead frame portion 103 including a first surface 104 and a recessed portion 105, the recessed portion 105 having a base 106 recessed from the first surface 104 and a side wall 107 that connects the base 106 to the first surface 104. The recessed portion 105 is configured to receive the electronic component 102 and secure said electronic component 102 to the lead frame portion 103 with an adhesive 108 that extends within the recessed portion 105, the side wall 107 of the recessed portion 105 acting as a barrier to control the bleeding of adhesive 108. This may increase the adhesive fillet height and improve the strength of the connection between the lead frame and the electronic component.

The electronic component 102 which the lead frame assembly 101 is configured to receive may be one of a range of electronic components. In one example the electronic component 102 is a capacitor but it will be appreciated that a range of electronic components 102 may be mounted on a lead frame in this manner. Examples of electronic components 102 which may be mounted on a lead frame in a recessed portion 105 may include, but are not limited to: capacitors, transistors, resistors, or diodes.

The adhesive 108 used to secure the electronic component 102 to the lead frame which readily bonds to lead frame and/or oxidation prevention materials and to the exterior of the electronic component 102 in question. In some examples the adhesive 108 may be conductive, this is particularly advantageous when directly forming electrical contacts between the electronic component 102 and the lead frame. Electrically conducting will be appreciated to mean that the medium conducts electricity under the normal operating parameters and environment of the lead frame assembly's 101 intended application. The skilled person will appreciate that a wide range of such adhesives 108 exist. Some examples of suitable adhesives 108 include epoxy adhesive or die attach adhesive or solder. The skilled person will appreciate that an insulating adhesive 108 may be used for bonding the electronic component 102 to the lead frame portion 103.

As shown in figure 2, the recessed portion 105 may be sized such that the electronic component 102 extends beyond the height of the first surface 104 out of the recess. The depth of the recessed portion 105 comprises the height of the side wall 107 extending between the first surface 104 and the base 106 of the recessed portion 105. The maximum depth of the recessed portion 105 may be related to the thickness of the leadframe and/or its ductility. Thus the depth is preferably up to an amount whereby stamping or forming of the recessed portion does not lead to fracture of the leadframe. For example, if the lead frame portion 103 were of copper then it has been found that the maximum depth of the recessed portion 105 may be between 40% - 60% of the thickness of the lead frame portion 103.

Further, the recessed portion 105 is sized to receive at least a portion of the electronic component 102 within the recess 105. In some examples the recessed portion may be of a size and shape complementary to the size and shape of the electronic component it is configured to receive or a part of the electronic component it is configured to receive. Thus, the side wall may surround or partially surround the electronic component. The side walls 107 may be perpendicular to the base 106. The junction between the base and the side walls may comprise a right angle or be tapered. In some examples the lead frame is configured to receive adhesive 108 over the base 106 and the side wall 107 to engage with a corresponding base and side wall of the electronic component 102.

The adhesive 108 may comprise a flowable material, such as a liquid or paste during fabrication and therefore controlling its movement once applied to the lead frame during fabrication is important.

The side wall 107 of the recessed portion 105 provides a barrier or retaining surface against which the adhesive 108 can be retained, thereby acting to reduce the adhesive 108 bleeding. This provides for a greater surface contact area between the adhesive 108 and the electronic component 102. Thus, typically, the lead frame is arranged with the first surface horizontal during fabrication and, accordingly, the side wall provides a substantially vertical retaining wall for controlling adhesive flow. The adhesive 108 may or may not extend over the entirety of the base 106 of the recessed portion 105. The base 106 of the recessed portion 105 is, in this example, substantially parallel to the first surface 104. Having the base 106 of the recessed portion 105 parallel to the first surface 104 allows the electronic component 102 to be easily mounted parallel to the lead frame which may be desirable for space efficient design of an electronic device.

The first surface 104 of the lead frame portion 103 may be a common surface to a larger lead frame surface, however it will be appreciated that the first surface 104 may be any portion of a lead frame such as a raised area or an isolated portion of the lead frame.

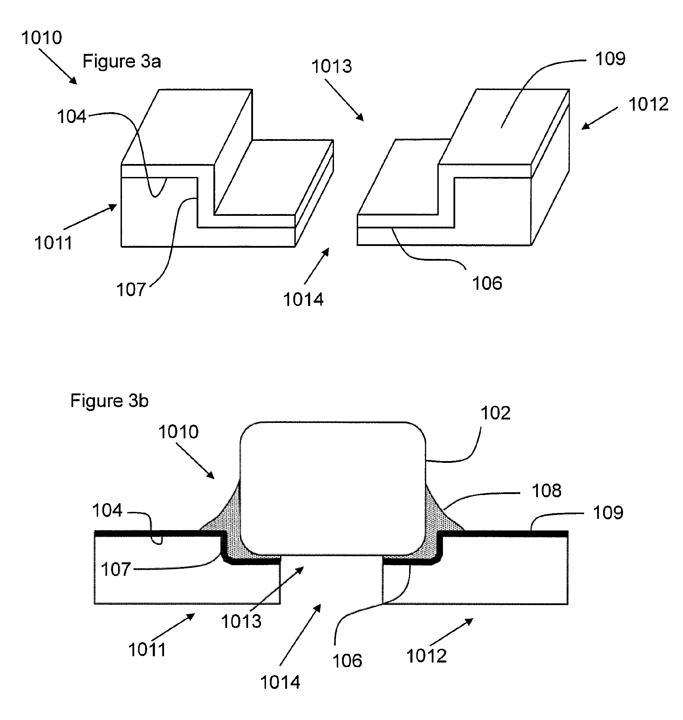

In some examples, such as those shown in figures 3A and 3B, an oxidation prevention layer 109 extends over at least a portion of the lead frame portion 1011, 1012. In this example the oxidation prevention layer 109 serves to prevent the oxidation of the lead frame. It will be appreciated that other layers for other functions may be present. Further, in this example the oxidation prevention layer 109 is of silver, however it will be appreciated that other materials may be used to form an oxidation prevention layer 109 such as silver, gold, tin, nickel or others. The oxidation prevention layer 109 may be applied over the entirety of the lead frame assembly 1010, including the first surface 104, the side wall 107 and the base 106 of the recessed portion 1013. Alternatively, the oxidation prevention layer 109 may be formed over only one of these surfaces. It will be appreciated that, when an oxidation prevention layer 109 is formed over a surface of the lead frame portion 103, then any feature described as being in contact with a specific surface of the lead frame will be indirectly in contact with that surface via the oxidation prevention layer 109.

Figures 3A and 3B show an example of the present disclosure wherein the lead frame assembly 1010 further comprises a first terminal portion 1011 and a second terminal portion 1012. The first terminal portion 1011 faces the second terminal portion 1012 and forms an adjacent side of the recessed portion. The first terminal portion 1011 and the second terminal portion 1012 may be separated by a gap 1014. As shown in Figure 3B, the first terminal portion 1011 receives a first side of the electronic component 102 and the second terminal portion 1012 receives a second side of the electronic component spaced from the first. Thus, the terminal portions 1011, 1012 may receive electrically separate electrodes of the electronic component 102, such as terminals of a capacitor located on the first and second sides of the component 102. While a gap 1014 has been provided between the two lead frame portions 1011, 1012, it will be appreciated that a material having properties different to those of the lead frame portions could also serve to separate or electrically isolate the first terminal portion 1011 from the second terminal portion 1012. For example, an insulating material could be arranged between the first terminal portion 1011 and the second terminal portion 1012 such as a non-conductive polymer.

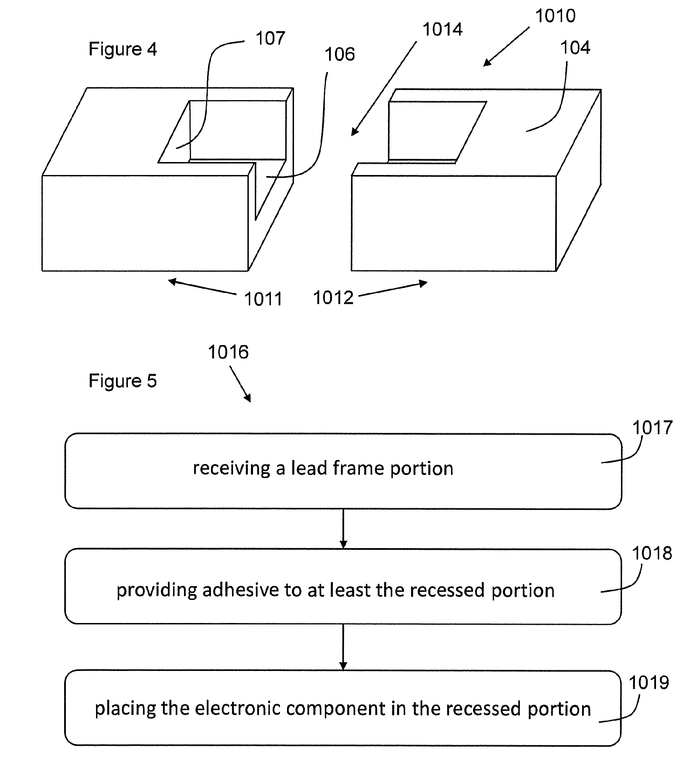

Figures 2, 3A and 3B show examples wherein the side wall 107 comprises a single face to control adhesive flow, however, the side wall 107 may have a plurality of faces or sections, such as in the example depicted in figure 4. Figure 4 shows an example wherein each side wall 107 of each recessed portion 1013 comprises three faces. It will be appreciated that the recessed portion 1013 is not required to have a rectangular cross section but may have any appropriate 2-dimensional cross section, such as a circle or a polygon. The shape of the cross section of the recessed portion 1013 may be complementary to the electronic component 102. While the example shown in figure 4 comprises a first terminal portion 1011 and a second terminal portion 1012, it will be appreciated that an example may exist wherein only the first terminal portion 1011 is provided that corresponds to one, two, three, four or more sides of an electronic component.

In another example of the present disclosure there is provided an assembly comprising a lead frame assembly 101, 1010 as described herein and shown in figures 2 and 3B in combination with an electronic component 102 secured thereto by an adhesive 108.

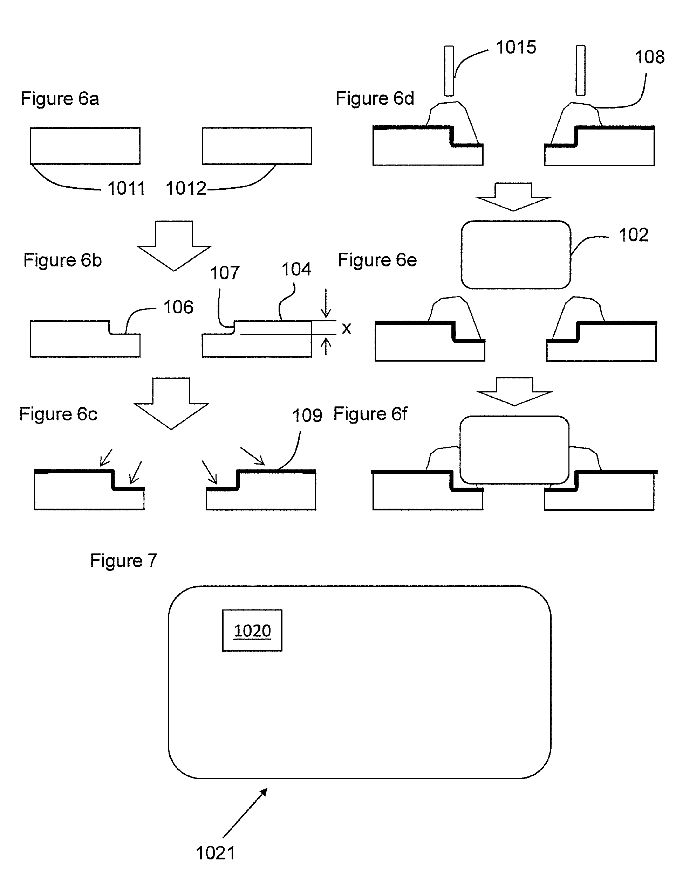

Figure 5 illustrates an example method 1016 for fabricating the assembly. Figures 6A- 6F graphically represent method steps which may be performed to fabricate the assembly.

With reference to Figure 5, the method 1016 for fabricating an assembly comprises:
receiving 1017 a lead frame portion comprising a first surface and a recessed portion, the recessed portion having a base recessed from the first surface and a side wall;
providing 1018 adhesive to at least the recessed portion for securing an electronic component to the lead frame; and
placing 1019 the electronic component in the recessed portion such that it is secured to the lead frame by the adhesive that extends at least between the lead frame portion, said side wall providing bleeding of the adhesive and the side wall of the recessed portion controls the bleeding of the adhesive.

Receiving the lead frame may comprise receiving a lead frame configured to have a first terminal 1011 and a second terminal 1012. After forming the recessed portion, the recess of the lead frame portion may comprise a first terminal portion and a second terminal portion formed within the recessed portion for contacting separate terminals of the electronic component and the side wall adjacent the second terminal portion is configured to control adhesive bleeding. Figure 6B, described below shows a lead frame assembly of this type.

Figure 6A shows an example of receiving a lead frame portion with a first terminal portion 1110 and a second terminal portion 1210.

Figure 6B shows the lead frame portion being stamped in order to form a recessed portion. Techniques other than stamping, such as photo etching, may be used. Forming a recessed portion by one of these techniques provides a recessed portion with a base 106 and a side wall 107 and having a depth, x.

Figure 6C shows the coating of the lead frame assembly with an oxidation prevention layer 109. The layer can be applied by a range of techniques, such as CVD deposition. Preventing the oxidation of the lead frame may advantageously serve to improve the performance of the device.

Figure 6D shows the step of applying adhesive to at least the recessed portion for securing the electronic component to the lead frame. As shown in figure 6D, the adhesive may be applied initially along the base and the side wall of the recessed portion. Some portion of the adhesive may contact the first surface prior to the placement of the electronic component, or the adhesive may spread across to the first surface when the electronic component is placed. The adhesive may be applied by dispensers 1015 which may spray or pour the adhesive onto the appropriate surfaces.

Figure 6E shows the electronic component being lowered onto the lead frame assembly.

Figure 6F show the steps of applying the electronic component 102 to the adhesive 108 applied lead frame assembly. The electronic component 102 may displace some of the adhesive and/or cause spreading out of the adhesive. A solder reflow step may lead to further spreading out of the adhesive. However the side wall acts to retain the adhesive around the electronic component. Thus, the adhesive may be applied only on the base of the recessed portion and lowering of the electronic component may displace adhesive against the side wall, which consequentially acts to retain it around the electronic component.

Figure 7 shows an electronic device 1021 including an assembly 1020 comprising an electronic component 102, an adhesive 108 and a lead frame assembly 101, 1010 as described herein. It will be appreciated that a range of electronic devices 1021 may include the assembly 1020 described in this disclosure. Some examples of electronic devices may include: a sensor, an amplifier, a mobile phone or mobile phone mast, a computer, a satellite or an automobile.

While the disclosure is amenable to various modifications and alternative forms, specifics thereof have been shown by way of example in the drawings and will be described in detail. It should be understood, however, that other examples, beyond the particular examples described, are possible as well. All modifications, equivalents, and alternative examples falling within the spirit and scope of the appended claims are covered as well.

The instructions and/or flowchart steps in the above Figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some examples the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Examples of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, examples have been presented in terms of a selected set of details. However, a person of ordinary skill in the art would understand that many other examples may be practiced which include a different selected set of these details. It is intended that the following claims cover all possible examples.

## Claims

1. A lead frame assembly configured to receive an electronic component, comprising a lead frame portion including a first surface and a recessed portion, the recessed portion having a base recessed from the first surface and a side wall,
the recessed portion configured to receive the electronic component and secure said electronic component to the lead frame portion with an adhesive applied to at least the recessed portion, said side wall arranged to provide control of the bleeding of adhesive.

2. The lead frame assembly of claim 1 further comprising an oxidation prevention layer extends over the base of the recessed portion.

3. The lead frame assembly of any preceding claim wherein the lead frame portion is of copper.

4. The lead frame assembly of any preceding claim wherein the oxidation prevention layer is of silver.

5. The lead frame assembly of any preceding claim wherein the recess is between 0.01 - 1 mm deep.

6. The lead frame assembly of any preceding claim wherein the electronic component to be received is a capacitor.

7. The lead frame assembly of any preceding claim wherein the recessed portion includes a first terminal portion and a second terminal portion formed within the recessed portion for contacting separate terminals of the electronic component and the side wall adjacent the second terminal portion is configured to control adhesive bleed.

8. The lead frame assembly of any preceding claim comprising a plurality of lead frame portions.

9. The lead frame assembly of any preceding claim wherein the side wall extends substantially perpendicular to the base of the recessed portion.

10. An assembly comprising a lead frame assembly as described in any of claims 1 to 9 having an electronic component mounted in its recessed portion by an adhesive.

11. A method of fabricating an assembly comprising:
receiving a lead frame portion comprising a first surface and a recessed portion, the recessed portion having a base recessed from the first surface and a side wall;
providing adhesive to at least the recessed portion for securing an electronic component to the lead frame; and
placing the electronic component in the recessed portion such that it is secured to the lead frame by the adhesive, said side wall of the recessed portion controlling the bleeding of the adhesive.

12. The method of fabricating an assembly of claim 11 comprising the step of:
stamping the recessed portion into the lead frame portion.

13. The method of fabricating an assembly of claim 11 or 12 comprising the step of:
forming an oxidation prevention layer over the lead frame portion.

14. The method of fabricating an assembly of claims 11 to 13 wherein the recess of the lead frame portion comprises a first terminal portion and a second terminal portion formed within the recessed portion for contacting separate terminals of the electronic component and the side wall adjacent the second terminal portion is configured to control adhesive bleeding.

15. An electronic device including the assembly of claim 10.
